# EUROPEAN PATENT SPECIFICATION

(11) **EP 2 093 306 B1**
(45) Date of publication and mention of the grant of the patent: **29.11.2017**
(21) Application number: 07830048.0
(22) Date of filing: 18.10.2007
(51) Int. Cl.: H01J 9/02, H01J 11/12, H01J 11/40, C23C 14/08, C23C 14/56

(54) **PLASMA DISPLAY PANEL MANUFACTURING METHOD AND MANUFACTURING DEVICE**
VERFAHREN UND VORRICHTUNG ZUR HERSTELLUNG EINER PLASMAANZEIGETAFEL
PROCÉDÉ ET DISPOSITIF DE FABRICATION D'ÉCRAN À PLASMA

(30) Priority: 27.10.2006 JP 2006292962
(43) Date of publication of application: 26.08.2009
(73) Proprietor: Ulvac, Inc., Chigasaki-shi Kanagawa 253-8543 (JP)
(72) Inventor: IIJIMA, Eiichi, Chigasaki-shi Kanagawa 253-8543 (JP); HAKOMORI, Muneto, Chigasaki-shi Kanagawa 253-8543 (JP)
(74) Representative: D Young & Co LLP
(86) International application number: PCT/JP2007/070314
(87) International publication number: WO 2008/050662

(56) References cited:
- EP-A- 2 075 352
- JP-A- 5 234 519
- JP-A- 8 287 833
- JP-A- 11 213 869
- JP-A- 2002 129 311
- JP-A- 2004 010 943
- NAKAMURA N.: 'Plasma Gun o Mochiita PDP-yo MgO Seimaku Sochi' ELECTRONIC MATERIALS AND PARTS 2005, pages 208 - 212, XP008110301
- D.D Hass ET AL: "Reactive vapor deposition of metal oxide coatings", Surface and Coatings Technology, vol. 146-147, no. 147, 1 September 2001 (2001-09-01), pages 85-93, XP055151506, ISSN: 0257-8972, DOI: 10.1016/S0257-8972(01)01368-8

## Description

### Technical Field

The present invention relates to a production method and production apparatus for a plasma display panel (hereinafter, referred to as PDP), and more particularly, to formation of a protective layer for a dielectric layer of the PDP.

### Background Art

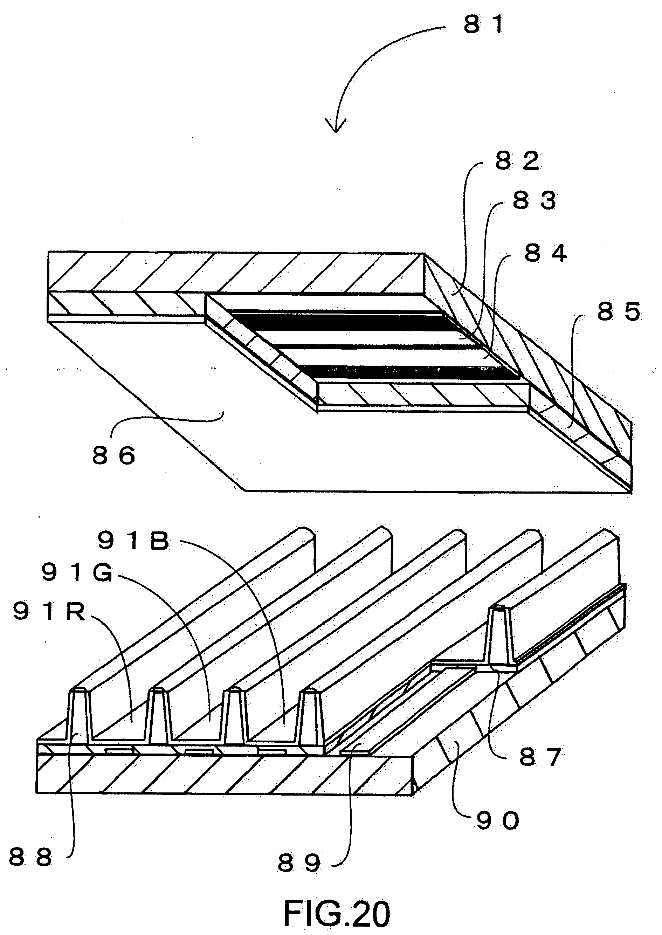

An AC-surface-discharge-type PDP currently a mainstream of PDPs is constituted of a front substrate including a scanning electrode, a sustaining electrode, a dielectric layer, and a protective layer, and a back substrate including an address electrode, a barrier rib, and a phosphor (see Fig. 20).

As shown in Fig. 20, in an AC-surface-discharge- type PDP 81, two glass substrates are frit-sealed via a narrow gap filled with discharge gas. Address electrodes 89 are arranged on a back glass substrate 90 in a row direction, and a dielectric layer 87 is formed thereon. The dielectric layer 87 functions to protect the address electrodes 89 and enhance luminance as a white-color inversion layer. Barrier ribs 88 each have a height of about 100 to 150 µm, and inner walls of grooves formed by the barrier ribs 88 are sequentially coated with RGB phosphors (91R, 91B, and 91G).

A front substrate on a display side is provided with surface discharge electrodes constituted of a transparent electrode formed of ITO and the like and a bus electrode. The surface discharge electrodes are arranged in a pair with a discharge gap of about 50 to 100 µm interposed therebetween. The discharge electrodes are covered with a dielectric layer having a thickness of about 20 to 30 µm, and a surface protective layer formed of magnesium oxide (MgO) is formed thereon.

One cell as a display unit for each color is constituted of three electrodes, that is, the surface discharge electrodes (scanning electrode 83 and sustaining electrode 84) and the address electrode 89 respectively covered by dielectric layers 85 and 87 with respect to a discharge space circumferentially coated with the phosphors. The scanning electrodes 83 are sequentially applied with scanning pulses of a negative potential, and, in sync therewith, the address electrodes are applied with data pulses of a positive potential according to display data. As a result, writing discharge is caused selectively. Subsequently, AC sustain discharge pulses are applied between the sustaining electrodes and the scanning electrodes so that sustain discharge of the written cell is caused. As a result, luminescent display is realized.

As described above, MgO is mainly used for the protective layer. In addition to the function as the protective layer, MgO is required to have a large secondary electron emission coefficient. Due to lowering of cost and an increase in demand of PDPs, sizes of glass substrates are becoming larger and larger and a throughput of production apparatuses for depositing MgO as the protective layer of the PDP is becoming shorter and shorter.

It is known that MgO has an orientation regarding a crystal growth, and properties thereof differ depending on the orientation of growth. By changing deposition conditions, MgO having crystal orientations of (111), (110), (100), and the like can be deposited. In this regard, various methods have been developed for obtaining deposited layers having desired orientations.

For example, focusing on sputter resistance as the protective layer, there is a method of obtaining an MgO layer having a (110) orientation (see Patent Document 3). In an MgO crystalline structure, channeling is apt to occur more in a (110) surface than a (111) oriented surface. In other words, incident ions enter the crystal deeply with ease, and it is difficult for sputtering to occur in the vicinity of the surface. The MgO layer is formed by a high-frequency ion plating method in an atmosphere with a suitable oxygen partial pressure and water vapor partial pressure.

Focusing on secondary electron emission, there is a method of obtaining an MgO layer having a (111) orientation (see Patent Document 1), which is a method that uses a vacuum vapor deposition method carried out in an oxygen atmosphere or an ion assisted vapor deposition method that involves irradiating ion beams on a vapor deposition surface.

However, a vapor deposition method that uses electron beams, the controllability of which is better than that of ion beams, is desirable for obtaining an MgO layer of higher accuracy. In this case, for obtaining the MgO layer with a (111) orientation by the vapor deposition method that uses electron beams, it has been necessary to carry out deposition at a substrate temperature of 230°C or more or form the layer at a deposition rate of 1.5 Å/sec or more and 3 Å/sec or less (see Patent Document 2).

This method uses electron beams to first form, as a base, a magnesium oxide layer having a (111) orientation at a substrate temperature of 230°C or more and 350°C or less or at a deposition rate of 1.5 Å/sec or more and 3 Å/sec or less. Then, a protective layer having the (111) orientation can be obtained by the electron beam vapor deposition at a low substrate temperature and high deposition rate.

However, since two processes of forming a base and forming a protective layer are required and conditions for those processes are different, it has been impossible to satisfy recent demands for a significant improvement in productivity.

Patent Document 1: Japanese Patent Application Laid-open No. Hei 5-234519 (p. 3, Fig. 3)
Patent Document 2: Japanese Patent Application Laid-open No. Hei 8-287833 (p. 3, Table 1)
Patent Document 3: Japanese Patent Application Laid-open No. Hei 10-106441 (p. 3, Table 1)
Any of NAKAMURA N. ("MgO film formation equipment for PDP using the plasma gun", ELECTRONIC MATERIALS AND PARTS, 2005, pages 208 - 212), JP11213869, JP08287833, JP05234519 discloses a production method for a PDP comprising the step of forming, as the protective layer, an MgO layer having a (111) orientation, in which the MgO layer is formed by an electron beam vapor deposition method. NAKAMURA N. further discloses a production apparatus for production of a PDP according to the preamble of present claim 4.

### Disclosure of the Invention

### Problems to be solved by the Invention

From the past, in a PDP production apparatus, an in-line vapor deposition apparatus in which a substrate is mounted on a carrier which is then conveyed above a evaporation source for deposition is used for the reasons that it is difficult to form a layer uniformly in a state where a substrate is fixed to a large glass substrate of about 60 inches in diagonal and that it is necessary to develop a vacuum-compatible robot for transferring large substrates, that is necessary for transferring heavy glass substrates for PDPs.

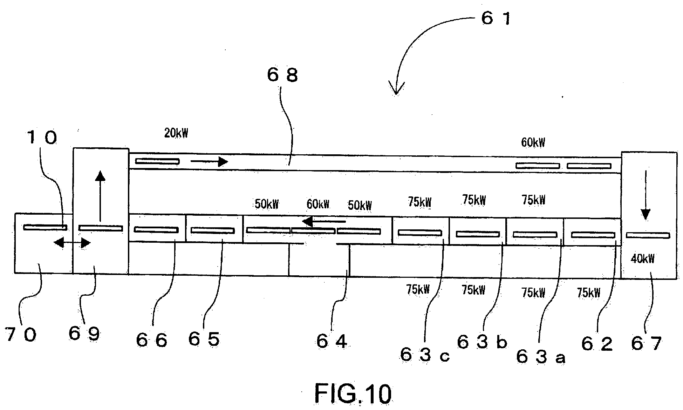

An apparatus structure of the in-line vapor deposition apparatus for PDPs is shown in Fig. 10. The apparatus is constituted of 7 chambers, that is, a loading chamber 62, heating chambers 63a, 63b, and 63c, a vapor deposition chamber 64, a cooling chamber 65, and an unloading chamber. First, a glass substrate 10 is set on a carrier (not shown) by a robot (not shown) at a substrate mounting and demounting position 70. The carrier is conveyed to the loading chamber 62 and, after exhaustion, sequentially conveyed to the heating chambers 63a, 63b, and 63c to be degassed by heating. After that, the carrier is conveyed to the vapor deposition chamber 64. In the vapor deposition chamber, the carrier is sequentially conveyed above evaporation sources so that an MgO film is formed on the glass substrate 10. Then, the carrier is cooled in the cooling chamber 65, passes through the unloading chamber 66, and returns to the substrate mounting and demounting position 70.

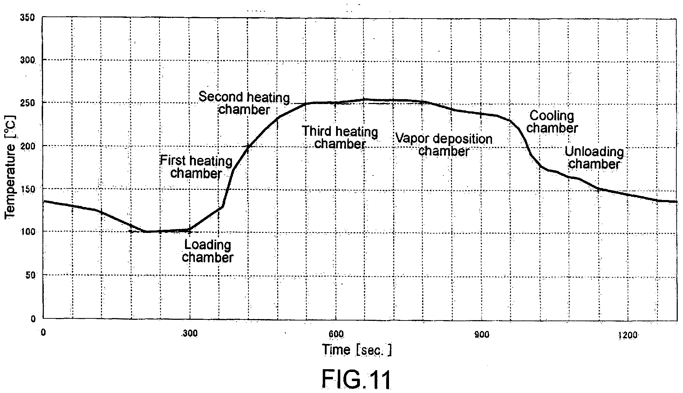

Specifically, as shown in Fig. 11, a PDP production apparatus 61 shown in Fig. 10 deposits MgO by the steps of:
(A) placing a glass substrate in a loading chamber;
(B) moving the glass substrate to heating chambers;
(C) heating the glass substrate to high temperature (200 to 250°C) in the heating chambers;
(D) moving the glass substrate to a vapor deposition chamber;
(E) depositing MgO on the glass substrate at high temperature (200 to 250°C) and at a rate of 4000 Å*m/min in a dynamic rate (140 Å/sec in static rate);
(F) moving the glass substrate to a cooling chamber;
(G) cooling the glass substrate;
(H) moving the glass substrate to an unloading chamber; and
(I) unloading the glass substrate from the unloading chamber.

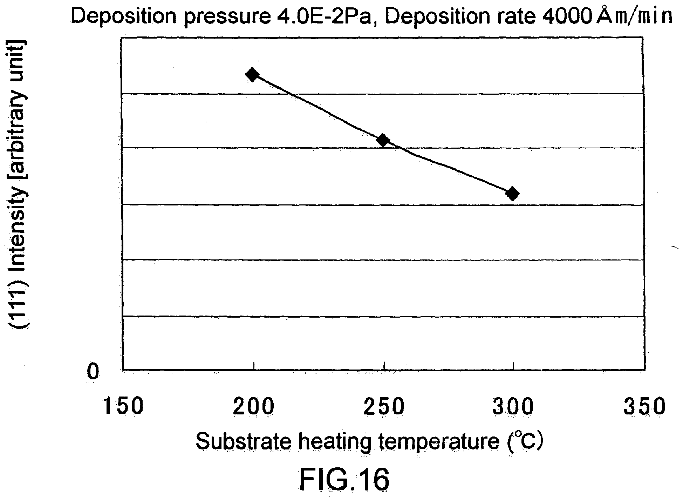

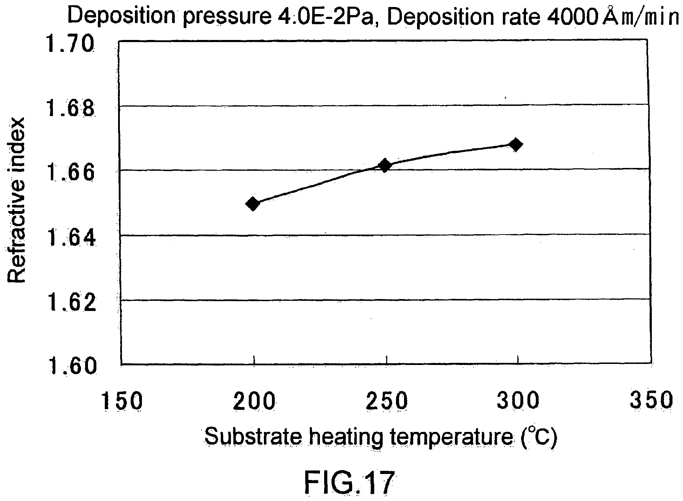

In the deposition in the PDP production apparatus of the related art, regarding a crystal orientation, whereas a layer having a better (111) orientation can be obtained when the substrate temperature is low (see Fig. 16), a film density and a refractive index tend to be better when the substrate temperature is high (see Fig. 17). Therefore, for satisfying both conditions, it has been necessary to heat the glass substrate within a range of 200 to 250°C.

Thus, in general, there have been the following problems in the process of forming a layer using electron beams in the related art.

Many heating chambers are necessary for heating a glass to a predetermined temperature within a throughput, with the result that the apparatus is enlarged in size and installment cost increases. For example, the PDP production apparatus shown in Fig. 10 uses three heating chambers. Moreover, heaters are disposed for preliminarily heating the glass substrate 10 even while the substrate is being moved to the heating chambers. It should be noted that wattages in the figure indicate wattages of heaters that are provided, though not shown in particular.

As the number of heating chambers increases, power consumption increases significantly. For example, in a case where MgO is deposited on a glass substrate from which 6 to 8 42-inch glass substrates can be cut out, with a tact time of 2 min, power of about 800 kW is necessary for the heaters in the PDP production apparatus of the related art. With the tact time of 1.5 min, power becomes 1200 kW or more.

Moreover, when mounting and demounting the glass substrate 10 using a robot, because the substrate needs to be cooled, maintenance cost of a clean room increases due to emission of energy therein.

In addition, special care needs to be taken for a retention method and bending of the glass substrate 10 due to rapid heating and cooling of the glass. In Fig. 10, the cooling chamber is prepared to raise cooling efficiency.

Although, for preventing MgO from adhering onto an extraction electrode portion of the PDP, a mask 15a is provided to the carrier 15 to limit a deposition area of the glass substrate 10, due to heating of the large glass substrate, even a slight difference between thermal expansion coefficients of the mask 15a and the glass substrate 10 makes it difficult for accuracy of the mask to be maintained. In this regard, the mask 15a is formed of a tensile material so as to adjust to expansion/contraction of the glass substrate 10.

Further, since the glass substrate and the carrier are heated, a vacuum chamber, a driving system, and a device introduction port need to be cooled sufficiently. Because a vapor pressure of polymers (oil) discharged to the atmosphere from an O-ring and a lubricating system as structural components of the apparatus depends on temperature, it is extremely difficult to perfectly prevent contamination.

### Means for solving the Problems

The problems above are all due to the high temperature during the deposition. If the temperature during the deposition can be set at room temperature, the problems above can be solved. As a result of research and development, the inventors have found a condition under which a deposition temperature can be lowered.

There are various other elements than temperature on which a layer quality depends. Examples thereof include a deposition rate and an oxygen partial pressure during the deposition. The inventors have considered that as long as the deposition conditions other than the temperature can be sufficiently satisfied, the temperature condition can be relatively relaxed. In this regard, the inventors have found a tendency for each of the conditions on the deposition other than the temperature and decided to improve them intensively. Furthermore, verification was conducted for each item required for the MgO layer.

It was also found that as long as an amount of impurities (C, CO, CO₂, etc.) taken-in in the MgO film can be reduced significantly, there is a possibility that the deposition condition can be relaxed.

In this regard, the MgO deposition rate of the electron beam vapor deposition apparatus was set to be 8000 Å*m/min or more in a dynamic rate and the substrate temperature was set to be 120°C or less. As a result, the amount of impurities taken-in in the MgO film was significantly reduced, and panel characteristics (cathode luminescence characteristics, write characteristics, etc.) expected of the MgO layer as the protective layer were significantly improved.

Thus, whether characteristics of a crystal orientation, film density/refractive index, transmittance, and the like are satisfied when the MgO deposition rate is set to 8000 Å*m/min or more was checked. As a result, it was confirmed that favorable film characteristics can be obtained even at room temperature (120°C or less).

In other words, the problems above can be solved by a production method for a plasma display panel (PDP) constituted of a front substrate including a scanning electrode, a sustaining electrode, a dielectric layer, and a protective layer, and a back substrate including an address electrode, a barrier rib, and a phosphor, the production method including the step of forming, as the protective layer, an MgO film having a (111) orientation, and in that the MgO film is formed by a vapor deposition method at a deposition rate of 8000 Å*m/min or more.

Moreover, the problems above can be solved by a production apparatus for a plasma display panel constituted of a front substrate including a scanning electrode, a sustaining electrode, a dielectric layer, and a protective layer, and a back substrate including an address electrode, a barrier rib, and a phosphor, the production apparatus including means for forming, as the protective layer, an MgO film having a (111) orientation, and in that the means deposits the MgO film at a deposition rate of 8000 Å*m/min or more.

### Effect of the Invention

MgO deposition at room temperature (120°C or less) became possible.

Further, a throughput of production equipment was significantly improved.

Furthermore, regarding the improvement of the two points above, the following subsidiary effects were obtained, thus solving the problems above.
- The heating chambers and the cooling chamber were removed from the MgO deposition apparatus, with the result that the apparatus became compact.
- The heater mechanism was removed from the vapor deposition chamber of the related art that has required the heating mechanism, with the result that the structure became simple.
- The heating mechanism was removed from a return conveyor and an elevator, with the result that the structure became simple.
- Rate control of the tact time for the heating and cooling became unnecessary, with the result that the tact time of the apparatus was shortened remarkably. It has become possible to shorten 90 sec of the related art to 30 sec or less.
- Because heating is unnecessary, mask displacement was significantly improved.
- Because the process temperature is low, contamination was significantly suppressed, thus leading to improvement of film characteristics.
- The apparatus cost was reduced.
- Running cost was significantly reduced. Power was cut to 1/3 or less as that of the related art. Cooling water was reduced to 1/2 or less as that of the related art.
- A heat load amount with respect to the clean room was reduced to 1/3 or less as that of the related art.
- Handling of substrates and carrier conveyance became easier.

### Brief Description of Drawings

[Fig. 1] A schematic diagram of an in-line electron beam vapor deposition apparatus according to an embodiment of the present invention.
[Fig. 2] An explanatory diagram of electron beam evaporation sources used in a production method for a plasma display panel (PDP) according to the embodiment of the present invention. A plan view showing a positional relationship among pierce-type electron guns, ring hearths, and irradiation points.
[Fig. 3] A diagram showing an X-ray diffraction pattern of an MgO film of the present invention.
[Fig. 4] A graph showing a deposition rate in the production method for a plasma display panel (PDP) according to the embodiment of the present invention.
[Fig. 5] A schematic diagram of an experimental apparatus.
[Fig. 6] Evaporation sources of the experimental apparatus.
[Fig. 7] A diagram showing peak intensities as a result of an X-ray diffraction of the experimental apparatus.
[Fig. 8] A result of measuring transmittances in the experiment.
[Fig. 9] A result improving the transmittance. Deposition was carried out while replenishing an adequate amount of oxygen.
[Fig. 10] A schematic diagram of an in-line electron beam vapor deposition apparatus of the related art.
[Fig. 11] A heating process of the in-line electron beam vapor deposition apparatus of the related art.
[Fig. 12] An explanatory diagram of electron beam evaporation sources used in a production method for a plasma display panel (PDP) of the related art. A plan view showing a positional relationship among pierce-type electron guns, ring hearths, and irradiation points. An example where two electron guns are used is shown.
[Fig. 13] An explanatory diagram of the electron beam evaporation sources used in the production method for a plasma display panel (PDP) of the related art. A plan view showing the positional relationship among the pierce-type electron guns, the ring hearths, and the irradiation points. An example where four electron guns are used to increase a dynamic rate is shown.
[Fig. 14] A diagram of an X-ray diffraction pattern of an MgO film of the related art.
[Fig. 15] A graph showing a deposition rate in the production method for a plasma display panel (PDP) of the related art.
[Fig. 16] A graph showing a relationship between a substrate heating temperature and a (111) orientation intensity of the related art. When the deposition rate and a deposition pressure are constant, a (111) peak intensity decreases as the substrate temperature increases.
[Fig. 17] A graph showing a relationship between the substrate heating temperature and a refractive index of the related art. When the deposition rate and the deposition pressure are constant, the refractive index increases as the substrate temperature increases.
[Fig. 18] A diagram showing a relationship between an MgO incidence angle and a refractive index in a fixed deposition.
[Fig. 19] A diagram showing a relationship between the MgO incidence angle and the (111) orientation intensity in the fixed deposition.
[Fig. 20] A schematic diagram showing a basic structure of a plasma display panel (PDP) as an AC-type PDP. Two glass substrates are arranged opposed to each other via a narrow gap filled with discharge gas. The gap is partitioned by barrier ribs, and grooves between the partitions are each coated with a phosphor in any of three primary colors. A single cell selected by a scanning electrode of a front substrate and an address electrode of a back substrate corresponds to a display unit.
[Fig. 21] A side view showing a relationship between the evaporation sources and incidence angles. In the related art, a plurality of evaporation points (electron beam irradiation points) have been disposed in a direction in which a glass substrate is conveyed. At a time the vapor deposition is started, MgO is deposited onto the glass substrate at incidence angles of 30° and about 60°. Moreover, at a time the vapor deposition ends, MgO is deposited at incidence angles of about 60° and 30°.
[Fig. 22] Photographs of electron beam irradiation points (evaporation points), that each show a relationship between an output of the electron gun and an irradiation area. The larger the output, the larger the irradiation area.
[Fig. 23] An enlarged photograph of the electron beam irradiation point (evaporation point), that shows an example of an irradiation form.
[Fig. 24) A graph showing a current density range of electron beams with which splash is prevented.

### Description of Symbols

1 electron beam vapor deposition apparatus
2 vacuum chamber
3 pierce-type electron gun
4 ring hearth (evaporation material vessel, evaporation source)
9 shielding plate
10 glass substrate (front substrate)
11 evaporation material (MgO)
15 carrier
15a mask
26a permanent magnetic (north pole)
26b permanent magnetic (south pole)
31 plasma display panel (PDP) production apparatus
32 loading/unloading chamber
33 heating chamber
34 vapor deposition chamber
41 plasma display panel (PDP) production apparatus
42 loading chamber
43 transfer chamber
44 vapor deposition chamber
46 unloading chamber
47 front elevator
48 return conveyor
49 rear elevator
50 substrate mounting and demounting position
61 plasma display panel (PDP) production apparatus
62 loading chamber
63a, 63b, 63c heating chamber
64 vapor deposition chamber
65 cooling chamber
66 unloading chamber
67 front elevator
68 return conveyor
69 rear elevator
70 substrate mounting and demounting position
81 plasma display panel (PDP)
82 front substrate
83 scanning electrode
84 sustaining electrode
85 dielectric layer
86 protective layer (MgO)
87 dielectric layer
88 barrier rib
89 address electrode
90 back substrate
91R, 91G, 91B phosphor
P, P1, P2 electron beam irradiation point (evaporation point)

### Best Mode for Carrying Out the Invention

Hereinafter, specific embodiments to which the present invention is applied will be described in detail with reference to the drawings.

### (Embodiment 1)

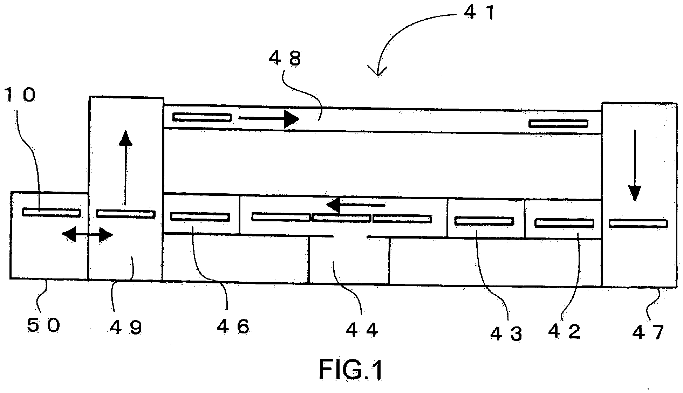

An embodiment of the present invention is shown in Figs. 1 to 3.

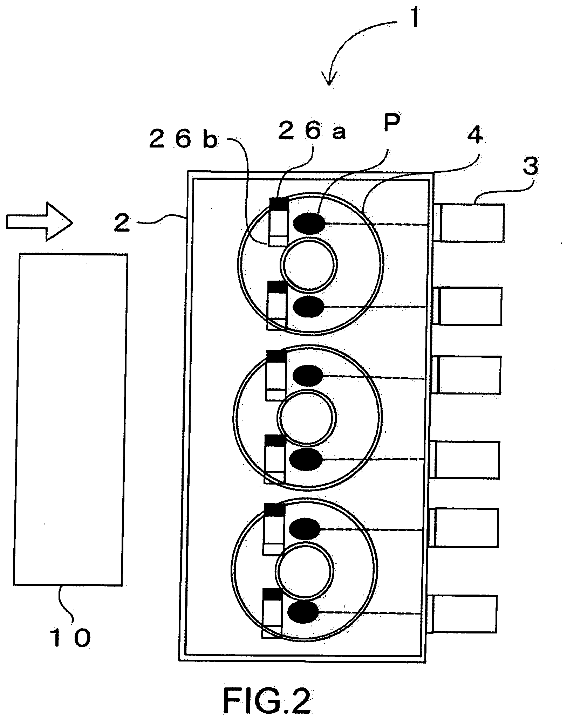

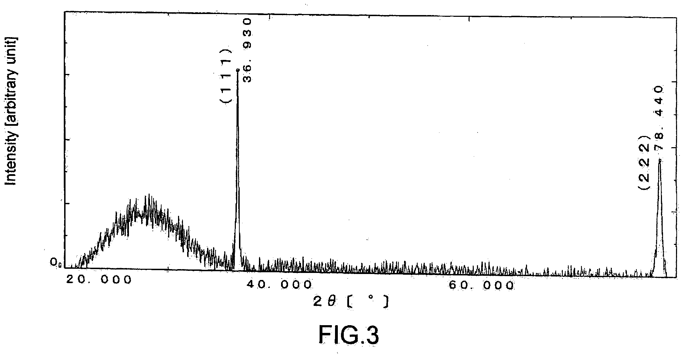

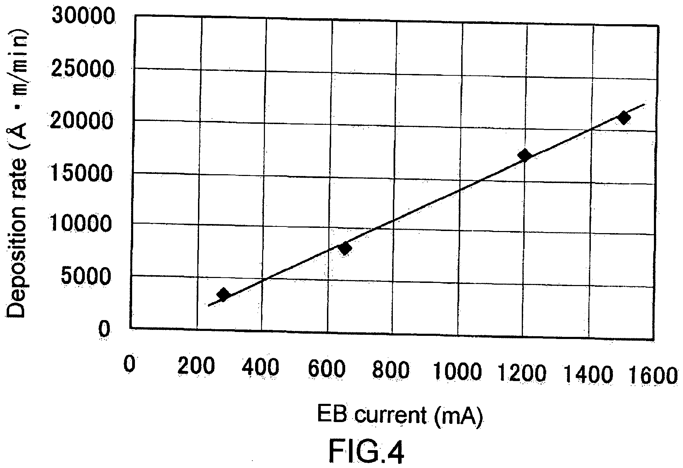

Fig. 1 shows a PDP production apparatus 41 according to the embodiment of the present invention. As compared to a PDP production apparatus of the related art (Fig. 10), two heating chambers and a cooling chamber have been removed. Fig. 2 is a diagram showing electron beam evaporation sources of this embodiment. Fig. 3 is a diagram of an X-ray diffraction pattern of an MgO film formed using the PDP production apparatus of this embodiment. Fig. 4 is a diagram showing a deposition rate of the PDP production apparatus according to the embodiment of the present invention.

As shown in Fig. 1, the PDP production apparatus 41 according to the embodiment of the present invention includes a loading chamber 42, a transfer chamber 43, a vapor deposition chamber 44, an unloading chamber 46, a front elevator 47, a rear elevator 49, and a substrate position 50, and does not require a heating process as in the related art, thus corresponding to a PDP production apparatus 61 of the related art (Fig. 10) from which heating chambers 63a, 63b, and 63c and a cooling chamber 65 have been removed.

The electron beam evaporation sources of the vapor deposition chamber 44 have a structure shown in Fig. 2. Three ring hearths and six pierce-type electron guns are provided, and a single electron gun 3 corresponds to a single irradiation point P. Permanent magnets 26a and 26b provided at a lower portion of the ring hearth 4 are used for controlling electron beams. It should be noted that the evaporation sources are each positioned so that an incidence angle of MgO vapors with respect to a glass substrate 10 becomes 30° or less.

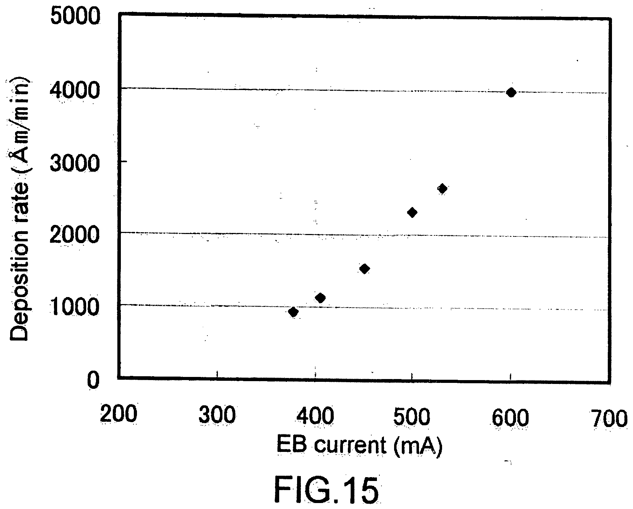

Moreover, each of the pierce-type electron guns 3 is a newly-developed large-capacity gun. MgO is deposited at a rate of 8000 Å*m/min or more using those six guns. The deposition rate shown in Fig. 4 is significantly increased as compared to that of the related art (Fig. 15).

The PDP production apparatus 41 above deposits MgO by the steps of:
(A) placing a glass substrate in a loading chamber;
(B) moving the glass substrate to a transfer chamber;
(C) moving the glass substrate to a vapor deposition chamber;
(D) depositing MgO on the glass substrate at room temperature (25 to 120°C) and at a rate of 8000 Å*m/min or more;
(E) moving the glass substrate to an unloading chamber; and
(F) unloading the glass substrate from the unloading chamber.

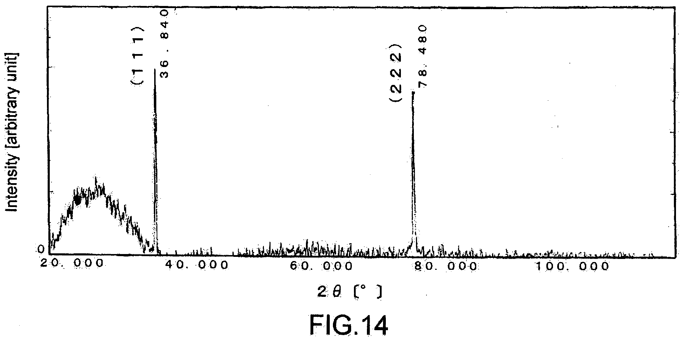

Fig. 3 shows an X-ray diffraction pattern of an MgO film obtained with a substrate temperature set at room temperature (120°C or less), using the PDP production apparatus 41 according to the embodiment of the present invention. As is apparent from the figure, a diffraction intensity peak is obtained at 36.93°, and an orientation is a (111) orientation. Regarding an X-ray diffraction pattern of an MgO film obtained by a method of the related art, a diffraction intensity peak is obtained at 36.84° (see Fig. 14). Therefore, it can be seen that the MgO film obtained by the method of the present invention is by no means inferior to that obtained by the method of the related art.

By the PDP production method and apparatus described heretofore, an MgO film having a (111) orientation can be obtained at room temperature.

### (Example)

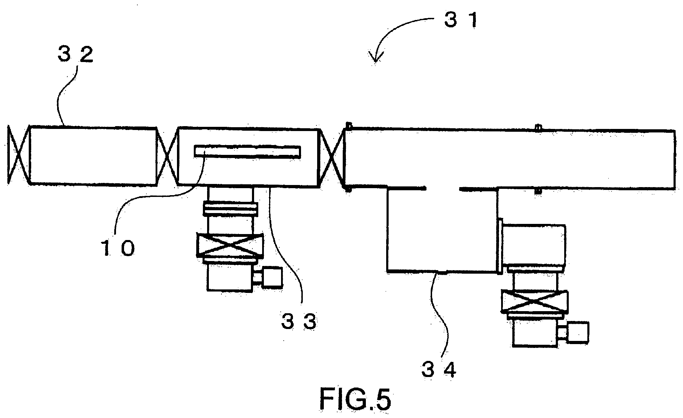

A confirmation test was conducted by an apparatus shown in Fig. 5.

This is a comprehensive example as a result of having improved respective parts for relaxing a temperature condition.

Hereinafter, a specific example of the deposition method at room temperature will be described based on a comparison with the related art.

First, characteristics required for the MgO film will be described.

Basic characteristics of an MgO film are evaluated based on a crystal orientation, film density/refractive index, and transmittance.

The crystal orientation currently required in production is a (111) orientation.

Further, a film density of 90% or more and a refractive index of 1.6 or more are also required. Sputter resistance improves as the film density increases.

The transmittance is 95% or more in ratio with respect to the glass substrate. MgO is required to have a high transmittance since it is used for a front plate of a PDP panel.

Next, improvements made for embodying the present invention will be described.

Regarding the film density and the refractive index, the inventors have also analyzed factors other than the substrate temperature at the time of the deposition and considered that, if a countermeasure is taken, satisfactory film characteristics can be obtained even when the substrate temperature is lowered. In this regard, the following discussion and countermeasure were taken.

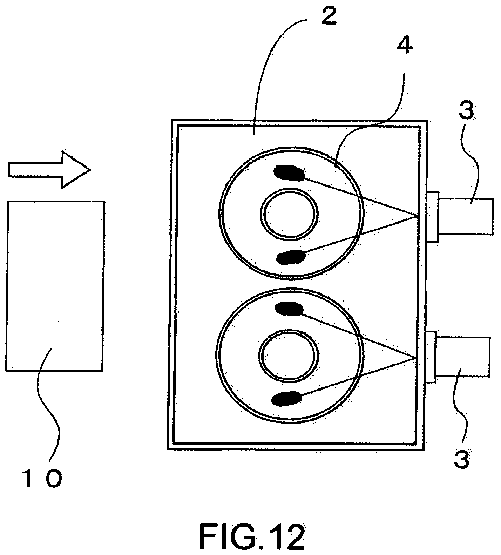

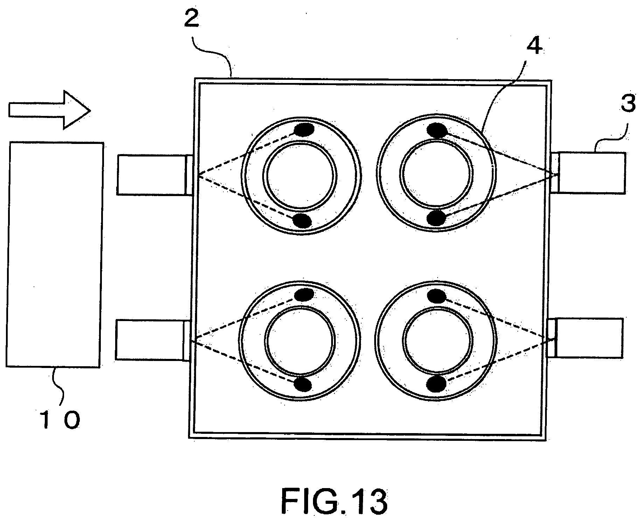

For increasing a dynamic rate to improve productivity, it is desirable to increase an amount of current of electron beams. However, in the case of the electron beam vapor deposition, whereas the deposition rate increases as a current value of the irradiated electron beams increases, if a large current is caused to flow for increasing the deposition rate, a phenomenon called splash in which a vapor deposition material is finely fractured and splashed due to a sharp increase in temperature of the evaporation sources occurs. A part of the vapor deposition material splashed by the splash may reach the glass substrate to thus cause lowering of a yield. In this regard, in the related art, for suppressing the splash and increasing the deposition rate, a countermeasure of increasing the number of electron guns and hearths as compared to the structure shown in Fig. 12 has been taken (see Fig. 13). In other words, the number of beam irradiation points has been increased to disperse the current.

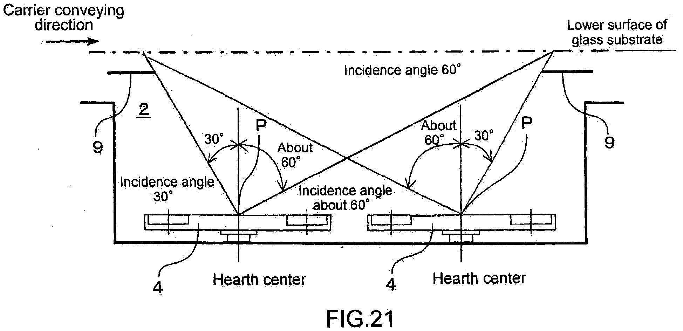

However, because the plurality of hearths, the plurality of electron guns, and a plurality of electron beam deflection apparatuses (not shown) are crammed inside, a degree of freedom in arrangement is apt to be low and the incidence angles of MgO from the evaporation sources with respect to the substrate are apt to increase due to mutual interferences between the electron beam deflection apparatuses, for example (see Fig. 21).

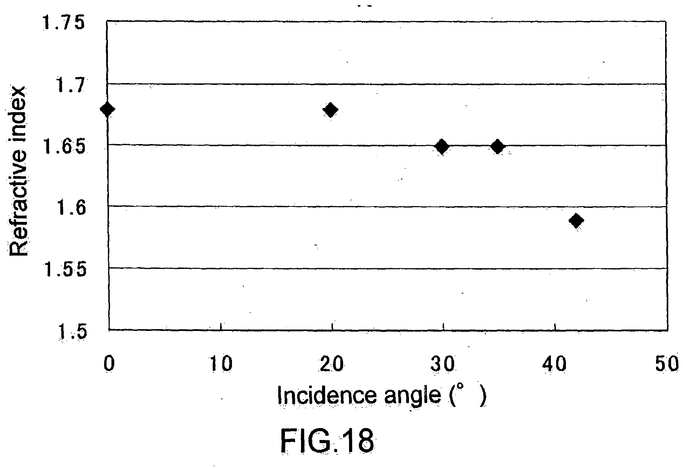

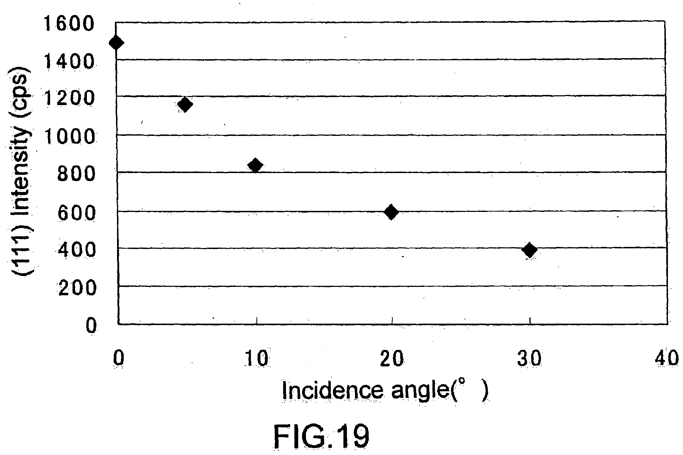

When the incidence angle of MgO from the evaporation source with respect to the substrate becomes large, the refractive index tends to decrease (see Fig. 18). Moreover, the crystal orientation becomes poor (see Fig. 19). Either value is larger than temperature-dependent properties during the deposition. Therefore, it can be expected that, if the incidence angle can be improved sufficiently, a condition under which all of the crystal orientation, the film density, and the refractive index are satisfied at a lower temperature can be obtained. The incidence angle is at least 30° or less, desirably 20° or less.

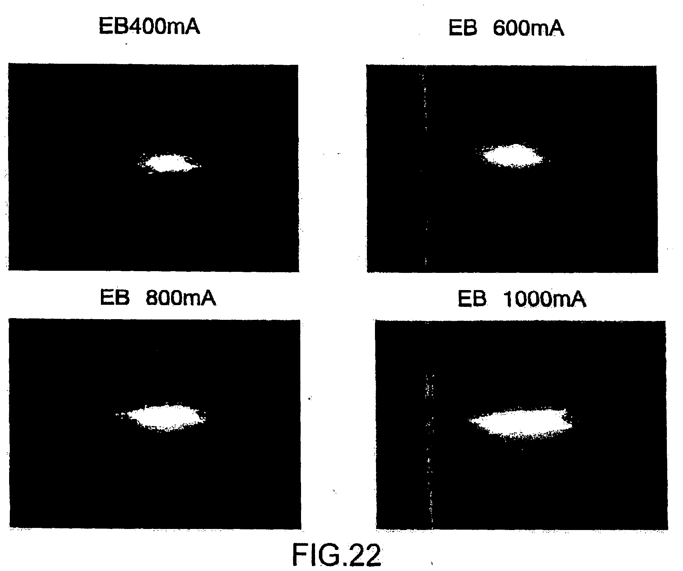

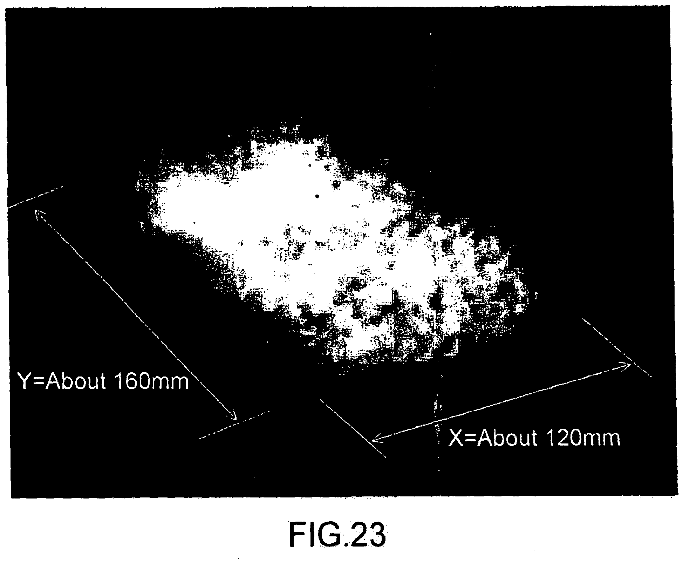

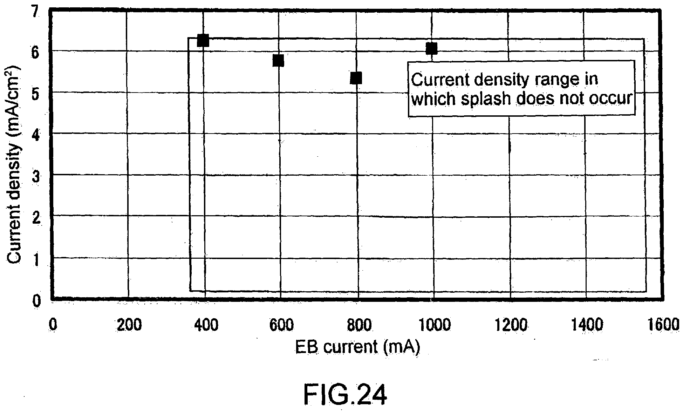

In this regard, the inventors have increased the output of the electron guns and widened the irradiation area by causing the electron beams to fluctuate (see Figs. 22 and 23). By widening the irradiation area to thus prevent the current density from increasing, a sharp increase in the temperature of the evaporation sources was suppressed to thus prevent the splash (see Fig. 24). Accordingly, it has become possible to increase the deposition rate with a smaller number of pierce-type electron guns, thus also resulting in an improvement of the incidence angle of MgO from the evaporation source with respect to the substrate.

The inventors have conducted an experiment after taking such countermeasures.

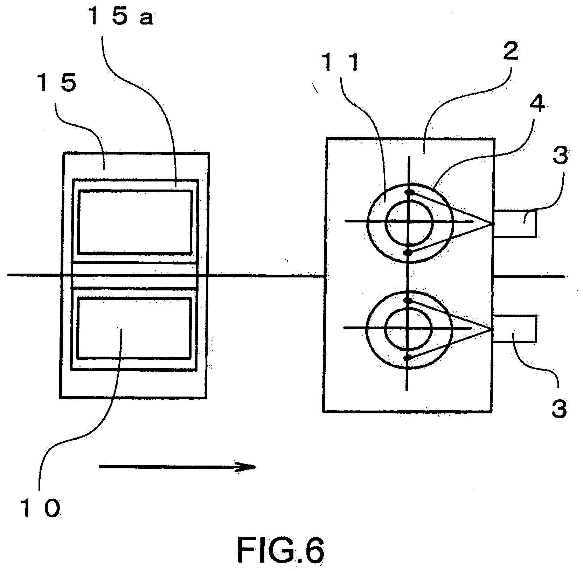

Fig. 5 shows a PDP production apparatus 31 used for the experiment. The apparatus is constituted of three chambers, that is, a loading/unloading chamber 32, a heating chamber 33, and a vapor deposition chamber 34. As shown in Fig. 6, the vapor deposition chamber 34 is an example of a load-lock-type vapor deposition apparatus equipped with two rotary ring hearths 4 as evaporation sources and two pierce-type electron guns 3. MgO is evaporated at four points on the ring hearths 4 so as to be deposited while the carrier 15 on which the glass substrate 10 is mounted is conveyed horizontally.

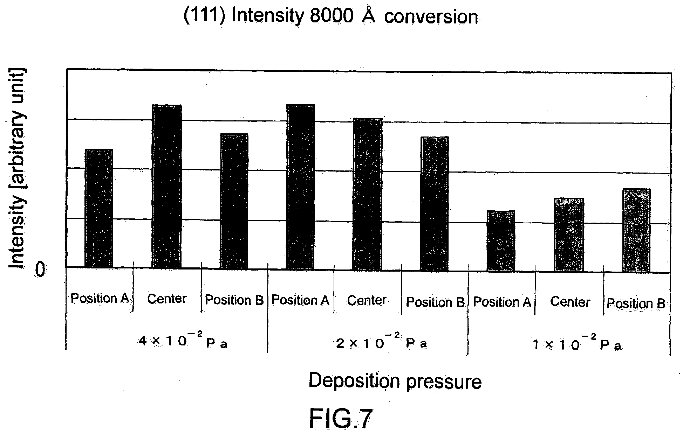

A result of the experiment is shown in Figs. 7 to 9.

Fig. 7 shows a result of measuring a peak intensity in a (111) orientation in the X-ray diffraction pattern at three points on the glass substrate, that is, a left end, a center, and a right end. It should be noted that films formed with different pressures in the vapor deposition chamber and each having a film thickness of 8000 Å are shown. It can be seen from the result that favorable characteristics can be obtained at pressures of 0.02 and 0.04 Pa, but it is also confirmed that a (111)-oriented layer can be obtained even at a pressure of 0.06 Pa.

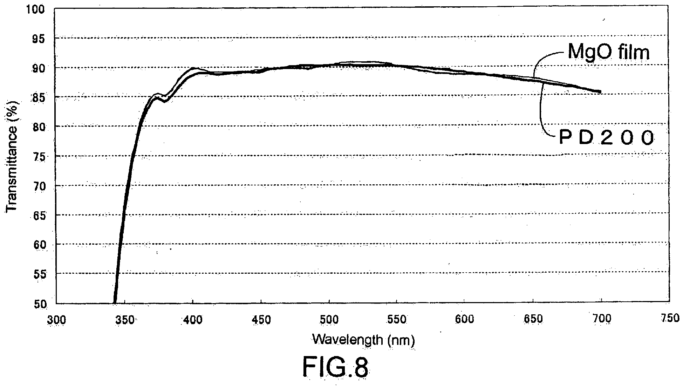

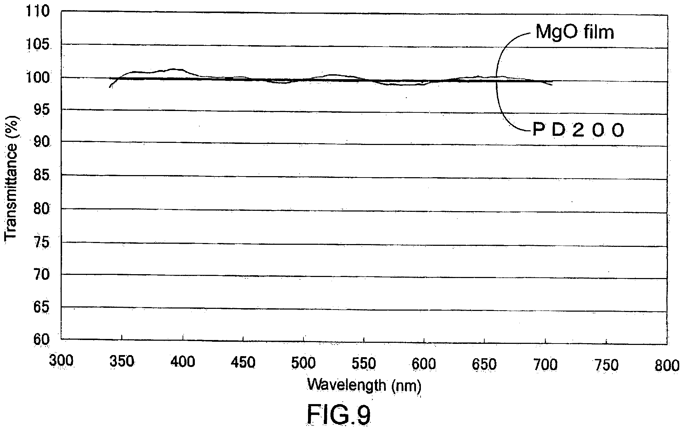

Fig. 8 shows transmittances. As a glass substrate to be a reference, PD 200 available from ASAHI GLASS CO., LTD. was used. Fig. 9 shows ratios obtained with PD 200 as a reference. The result shows transmittances of 95% or more.

As described above, the result of the measurement shows that an MgO film having favorable characteristics was obtained in any case.

Therefore, it was confirmed that by setting the temperature of the glass substrate at the time of the vapor deposition in the electron beam vapor deposition apparatus at room temperature (120°C or less) and setting the MgO deposition rate of the electron beam vapor deposition apparatus to be 8000 Å*m/min or more, a deposition that is by no means inferior to that carried out at a temperature of 200 to 250°C as in the related art can be carried out.

Heretofore, the embodiments of the present invention have been described. However, the present invention is of course not limited thereto, and various modifications can be made within the scope of the present invention defined in present claims 1 and 4.

For example, instead of the in-line electron beam vapor deposition apparatus and the load-lock-type electron beam vapor deposition apparatus, an electron beam vapor deposition apparatus of another system that uses pierce-type electron guns is also applicable.

Although the ring hearth 4 has been used as a vessel that accommodates the vapor deposition material in the electron beam vapor deposition apparatus according to the embodiments of the present invention, a crucible may be used instead.

## Claims

1. A production method for a plasma display panel (81) comprising a front substrate (82) including a scanning electrode (83), a sustaining electrode (84), a dielectric layer (85), and a protective layer (86), and a back substrate (90) including an address electrode (89), a barrier rib (88), and a phosphor (91R, 91G, 91B), the production method comprising the step of:
forming, as the protective layer (86) of the front substrate, an MgO layer having a (111) orientation,
in which the MgO layer is formed by an electron beam vapor deposition method at a deposition rate of 8000 Å*m/min or more and at a substrate temperature of 120°C or less.

2. The production method for a plasma display panel according to claim 1,
in which the MgO layer is formed under a pressure of 0.02 to 0.06 Pa.

3. The production method for a plasma display panel according to claim 1,
in which, when the MgO layer is formed, an incidence angle of MgO with respect to the front substrate is set to be 30° or less.

4. A production apparatus for production of a plasma display panel (81) constituted of a front substrate (82) including a scanning electrode (83), a sustaining electrode (84), a dielectric layer (85), and a protective layer (86), and a back substrate (90) including an address electrode (89), a barrier rib (88), and a phosphor (91R, 91G, 91B), the apparatus comprising
an evaporation source including a plurality of pierce-type electron guns for forming by an electron beam vapor deposition method, as the protective layer (86), an MgO layer having a (111) orientation, **characterised in that** the apparatus is adapted such that the evaporation source in operation deposits the MgO layer by the electron beam vapor deposition method at a deposition rate of 8000 Å*m/min or more on a substrate, forming said front substrate, at a substrate temperature of 120°C or less.

5. The production apparatus for a plasma display panel according to claim 4,
in which the evaporation source is positioned so that an incidence angle of MgO vapors with respect to the front substrate is set to be 30° or less.

## Patentansprüche

1. Verfahren zur Herstellung einer Plasmaanzeigetafel (81), umfassend ein Vordersubstrat (82), das eine Abtastelektrode (83), eine unterstützende Elektrode (84), eine dielektrische Schicht (85) und eine Schutzschicht (86) aufweist, und ein Rücksubstrat (90), das eine Adresselektrode (89), eine Barriererippe (88) und einen Phosphor (91R, 91G, 91B) aufweist, wobei das Verfahren zur Herstellung folgenden Schritt umfasst:
Formen einer MgO-Schicht mit einer (111)-Orientierung als Schutzschicht (86) des Vordersubstrats,
wobei die MgO-Schicht durch ein Elektronenstrahl-Aufdampfverfahren mit einer Aufdampfrate von 8000 Å*m/min oder mehr und mit einer Substrattemperatur von 120 °C oder weniger gebildet wird.

2. Verfahren zur Herstellung einer Plasmaanzeigetafel nach Anspruch 1,
wobei die MgO-Schicht unter einem Druck von 0,02 bis 0,06 Pa gebildet wird.

3. Verfahren zur Herstellung einer Plasmaanzeigetafel nach Anspruch 1,
wobei bei der Bildung der MgO-Schicht ein Auftreffwinkel von MgO in Bezug auf das Vordersubstrat auf 30° oder weniger eingestellt wird.

4. Vorrichtung zur Herstellung einer Plasmaanzeigetafel (81), die aus einem Vordersubstrat (82), das eine Abtastelektrode (83), eine unterstützende Elektrode (84), eine dielektrische Schicht (85) und eine Schutzschicht (86) aufweist, und einem Rücksubstrat (90), das eine Adresselektrode (89), eine Barriererippe (88) und einen Phosphor (91R, 91G, 91B) aufweist, besteht, wobei die Vorrichtung zur Herstellung Folgendes umfasst:
eine Verdampfungsquelle mit einer Vielzahl von Elektronenkanonen vom Pierce-Typ zum Bilden einer MgO-Schicht mit einer (111)-Orientierung als Schutzschicht (86) durch ein Elektronenstrahl-Aufdampfverfahren, **dadurch gekennzeichnet, dass** die Vorrichtung so eingerichtet ist, dass die Verdampfungsquelle im Betrieb die MgO-Schicht durch das Elektronenstrahl-Aufdampfverfahren mit einer Aufdampfrate von 8000 Å*m/min oder mehr und mit einer Substrattemperatur von 120 °C oder weniger auf ein Substrat aufdampft, wodurch das Vordersubstrat gebildet wird.

5. Vorrichtung zur Herstellung einer Plasmaanzeigetafel nach Anspruch 4,
wobei die Verdampfungsquelle so positioniert ist, dass ein Auftreffwinkel der MgO-Dämpfe in Bezug auf das Vordersubstrat auf 30° oder weniger eingestellt ist.

## Revendications

1. Procédé de production pour un écran à plasma (81) comprenant un substrat avant (82) comportant une électrode de balayage (83), une électrode de maintien (84), une couche diélectrique (85) et une couche protectrice (86), et un substrat arrière (90) comportant une électrode d'adressage (89), une nervure barrière (88) et un luminophore (91R, 91G, 91B), le procédé de production comprenant l'étape consistant à :
former, en tant que couche protectrice (86) du substrat avant, une couche de MgO ayant une orientation (111),
la couche de MgO étant formée par un procédé de dépôt en phase vapeur par faisceau d'électrons à une vitesse de dépôt de 8000 Å*m/min ou plus et à une température de substrat de 120 °C ou moins.

2. Procédé de production pour un écran à plasma selon la revendication 1,
dans lequel la couche de MgO est formée sous une pression de 0,02 à 0,06 Pa.

3. Procédé de production pour un écran à plasma selon la revendication 1,
dans lequel, quand la couche de MgO est formée, un angle d'incidence du MgO par rapport au substrat avant est réglé à 30° ou moins.

4. Appareil de production pour la production d'un écran à plasma (81) constitué d'un substrat avant (82) comportant une électrode de balayage (83), une électrode de maintien (84), une couche diélectrique (85) et une couche protectrice (86), et d'un substrat arrière (90) comportant une électrode d'adressage (89), une nervure barrière (88) et un luminophore (91R, 91G, 91B), l'appareil comprenant
une source d'évaporation comportant une pluralité de canons à électrons de type Pierce pour former par un procédé de dépôt en phase vapeur par faisceau d'électrons, en tant que couche protectrice (86), une couche de MgO ayant une orientation (111),
**caractérisé en ce que** l'appareil est adapté de telle sorte que la source d'évaporation dépose en fonctionnement la couche de MgO par le procédé de dépôt en phase vapeur par faisceau d'électrons à une vitesse de dépôt de 8000 Å*m/min ou plus sur un substrat, formant ledit substrat avant, à une température de substrat de 120 °C ou moins.

5. Appareil de production pour un écran à plasma selon la revendication 4,
dans lequel la source d'évaporation est positionnée de telle sorte qu'un angle d'incidence de vapeurs de MgO par rapport au substrat avant est réglé à 30° ou moins.
